# EUROPÄISCHE PATENTANMELDUNG

(11) **EP 3 396 297 A1**
(43) Veröffentlichungstag der Anmeldung: **31.10.2018**
(21) Anmeldenummer: 17000739.7
(22) Anmeldetag: 28.04.2017
(51) Int. Cl.: F28F 13/12, F28D 1/02, H01L 23/467, H05K 7/20

(54) **KÜHLVORRICHTUNG**

(71) Anmelder: Siemens Aktiengesellschaft, 80333 München (DE)
(72) Erfinder: Pfefferlein, Stefan, 90562 Heroldsberg (DE)

(57) **Zusammenfassung**

Die Erfindung betrifft eine Kühlvorrichtung (1) zur Kühlung mindestens eines elektronischen Bauelements (2), welche einen Kühlkörper (3), welcher eine äußere Mantelfläche (4), eine Grundflächenöffnung (5), eine gegenüberliegende Deckflächenöffnung (6) und eine Innenfläche (8) mit Kühlrippen (9) aufweist, umfasst, einen Kühlkörperdeckel (10) umfasst, ein rohrförmiges Kühlelement (17) umfasst und ein Schaufelrad (11) zum Erzeugen eines Kühlstroms (14) eines Kühlmediums (12) umfasst, wobei die Deckflächenöffnung (6) durch den Kühlkörperdeckel (10) verschlossen ist, wobei das rohrförmige Kühlelement (17) derart im Kühlkörperinnenraum (7) des Kühlkörper(3) angeordnet ist, dass zumindest einige der Kühlrippen (9) mit der Außenseite des rohrförmigen Kühlelements (17) in einem mechanischen Kontakt stehen, wobei das rohrförmige Kühlelement (17) in seinem Innenraum einen ersten Kühlkanal (13) bildet, durch welchen im Betrieb der Kühlvorrichtung (1) der Kühlstrom (14) in eine erste Kühlstromrichtung (18) geleitet wird, wobei ein zweiter Kühlkanal (16) zwischen der Innenfläche (8) des Kühlkörpers (3) und der Außenseite des rohrförmigen Kühlelements (17) gebildet wird, durch welchen der Kühlstrom (14) in eine zweite Kühlstromrichtung (19) geleitet wird, wobei ein Umlenkmittel den Kühlstrom (14) vom ersten zum zweiten Kühlkanal (13,16) oder vom zweiten zum ersten Kühlkanal (16,13) umlenkt und wobei der erste gegenüber dem zweiten Kühlkanal (13,16) derart angeordnet ist, dass die erste Kühlstromrichtung (18) entgegengesetzt zur zweiten Kühlstromrichtung (19) ist. Ferner betrifft die Erfindung einen elektrischen Umrichter (40) mit der erfindungsgemäßen Kühlvorrichtung (1).

## Beschreibung

Die Erfindung betrifft eine Kühlvorrichtung zur Kühlung mindestens eines elektronischen Bauelements. Die Erfindung betrifft weiterhin einen elektrischen Umrichter mit der erfindungsgemäßen Kühlvorrichtung.

Gleich ob für den Bereich der Energieversorgung, für das Umfeld der industriellen Automatisierungs- und Antriebstechnik oder für den Einsatz in Elektrofahrzeugen werden an elektrische Umrichter hohe Anforderungen gestellt, beispielsweise an deren dynamische Energiebereitstellung in allen Leistungsklassen verbunden mit einer geringen Verlustleistung, einer Bereitstellung von kleinen, platzsparenden Baugrößen und einer für dezentrale Anwendungen geforderten Einsatzfähigkeit auch unter Verwendung von geeigneten modularen Bauteilen, welche darüber hinaus kostengünstige Herstellungsverfahren ermöglichen.

Konzepte und deren technische Umsetzung bzgl. einer effizienten Entwärmung von elektronischen bzw. elektrotechnischen Bauelementen in elektrischen Umrichtern, wie beispielsweise die Entwärmung von Leistungshalbleitern, Leistungswiderständen oder auch Leistungskondensatoren, können das aufgezeigte Anforderungsumfeld entsprechend adressieren und zumindest einige der angesprochenen Anforderungen aus einer ganzheitlichen Betrachtung heraus verbessern.

Bei elektrischen Umrichtern für beispielsweise dezentrale Antriebseinheiten, welche mechanisch mit der elektrischen Maschine eng verbunden oder auch direkt in das Gehäuse der elektrischen Maschine integriert sind, kommt der effizienten Entwärmung der elektronischen bzw. elektrotechnischen Bauelemente in Bezug auf Ausnutzung vorgegebener, räumlich eng dimensionierter und aus thermischen Gesichtspunkten heraus ungünstiger Einbauplätze eine besondere Bedeutung zu.

Dies gilt für das genannte Beispiel umso mehr, da hier auch die räumlichen Nähe zu einer Umrichter-externen Wärmequelle, also der elektrischen Maschine, zu berücksichtigen ist.

Ein entsprechend dimensionierter und zentral angeordneter Kühlkörper des elektrischen Umrichters kann im Betrieb die Entwärmung der Verlustwärme erzeugenden elektrischen bzw. elektrotechnischen Bauelemente durchführen.

Vorzugsweise werden derartige Kühlkörper in einem geringen Aspektverhältnis aus deren Länge zu deren Breite bzw. zu deren Durchmesser ausgeführt. Dies resultiert aus einem gewollten Ausnutzen des Umfanges der Struktur des Kühlkörpers bei gleichzeitigem Erreichen eines möglichst geringen Bauraumes des Kühlkörpers als ein Bauteil des elektrischen Umrichters.

Damit bei eher kurzer Länge des Kühlkörpers im Betrieb des elektrischen Umrichters ausreichend Verlustwäre von den mit dem Kühlkörper mechanisch verbundenen elektronischen bzw. elektrischen Bauteilen abgeführt werden kann, sollte die Oberflächenstruktur des Kühlkörpers so groß wie möglich ausgeführt werden.

Dadurch wird allerdings auch der Druckverlust eines Kühlmediums am bzw. im Kühlkörper erhöht, was wiederum eine Erhöhung bzw. Etablierung von Aktivitäten zur verstärkten Entwärmung des Kühlkörpers selbst voraussetzt. Daraus folgt im Allgemeinen ein zusätzlicher bzw. erhöhter Platzbedarf für die Lösungen mittels oftmals zwangsgeführter Entwärmung des Kühlkörpers, wie beispielsweise der Einsatz von Lüftern zeigt. Oft geht diese Lösung auch einher mit der Erhöhung der Lautstärke und bei größeren Leistungen für den Eigenbedarf der Lüfter ebenfalls mit einer Verringerung des Wirkungsgrads des elektrischen Umrichters.

Ein weiteres Problem von meist luftgekühlten Standardkühlsystemen zeigt sich in einer für das Entwärmen verlorenen Kühlfläche des Kühlkörpers, weil zwei Öffnungen an zwei sich meist gegenüberliegenden Kühlkörperseiten des Kühlkörpers für einen Ein- und Austritt der Luft, welche in dieser Lösung den Kühlkörperinnenraum des Kühlkörpers durchströmt, auch zwei Kühlkörperflächen beanspruchen.

Weiterhin muss der Luftstrom möglichst ungehindert, also strömungstechnisch vorteilhaft, ein- und austreten können. Dadurch ist der Bauraum vor und hinter der Lufteintritts- und der Luftaustrittsöffnungen nur eingeschränkt für die Anordnung weiterer Bauteile im elektrischen Umrichter nutzbar. Die beschriebenen Aspekte führen zu einem Verlust an Integrationsdichte und eher ungenügender Bauraumausnutzung im beispielhaft betrachteten elektrischen Umrichter.

Der Erfindung liegt die Aufgabe zugrunde, eine Kühlvorrichtung bereitzustellen, welche im Gegensatz zum Stand der Technik eine Verbesserung der Bauraumnutzung bei gleichzeitiger Erweiterung von Kühlflächen zur Entwärmung elektronischer Bauelementen in elektrischen bzw. elektrotechnischen Geräten aufweist.

Die Aufgabe wird durch eine Kühlvorrichtung mit den in Anspruch 1 angegebenen Merkmalen gelöst. Ferner wird die Aufgabe durch einen elektrischen Umrichter mit der erfindungsgemäßen Kühlvorrichtung nach Anspruch 15 gelöst.

Der Erfindung liegt die Erkenntnis zugrunde, dass insbesondere eine verbesserte Führung des Kühlstroms eines Kühlmediums sowohl durch die geschickte Anordnung der Kühlungseinlässe und -auslässe des Kühlkörpers, wie auch die geschickte Anordnung der Kühlkanäle in dessen Innenraum, eine wesentliche Vergrößerung der verfügbare Kühlfläche zur Kühlung elektronischer Bauelemente entlang der Außenseite des Kühlkörpers bewirken kann.

Damit bietet es sich, nicht nur eine verbesserte Nutzung des verfügbaren Bauraumes für eine Kühlvorrichtung vorzusehen, sondern auch die Anordnungen aller Bauteile in elektrischen Geräten, beispielsweise in elektrischen Umrichtern, in Bezug auf deren Kompaktheit, Robustheit und Leistungsfähigkeit hin zu verändern.

Für die Lösung der Aufgabe wird eine Kühlvorrichtung zur Kühlung mindestens eines elektronischen Bauelements vorgeschlagen, welche einen Kühlkörper, welcher eine äußere Mantelfläche, eine Grundflächenöffnung, eine der Grundflächenöffnung gegenüberliegende Deckflächenöffnung und eine Innenfläche mit Kühlrippen aufweist, umfasst, welche einen Kühlkörperdeckel umfasst, welche ein rohrförmiges Kühlelement umfasst und welche ein Schaufelrad mit Schaufeln zum Erzeugen eines Kühlstroms eines Kühlmediums umfasst, wobei die Deckflächenöffnung durch den Kühlkörperdeckel verschlossen ist, wobei das rohrförmige Kühlelement derart im Kühlkörperinnenraum des Kühlkörper angeordnet ist, dass zumindest einige der Kühlrippen mit der Außenseite des rohrförmigen Kühlelements in einem mechanischen Kontakt stehen, wobei das rohrförmige Kühlelement in seinem Innenraum einen ersten Kühlkanal bildet, durch welchen im Betrieb der Kühlvorrichtung der Kühlstrom in eine erste Kühlstromrichtung geleitet wird, wobei ein zweiter Kühlkanal zwischen der Innenfläche des Kühlkörpers und der Außenseite des rohrförmigen Kühlelements gebildet wird, durch welchen im Betrieb der Kühlvorrichtung der Kühlstrom in eine zweite Kühlstromrichtung geleitet wird, wobei ein Umlenkmittel im Betrieb der Kühlvorrichtung den Kühlstrom vom ersten Kühlkanal zum zweiten Kühlkanal oder vom zweiten Kühlkanal zum ersten Kühlkanal umlenkt und wobei der erste Kühlkanal gegenüber dem zweiten Kühlkanal derart angeordnet ist, dass die erste Kühlstromrichtung im Wesentlichen entgegengesetzt zur zweiten Kühlstromrichtung ist.

Die mit der erfindungsgemäßen Kühlvorrichtung vorgeschlagene Führung des Kühlstroms durch den ersten und den zweiten Kühlkanal mittels der Umlenkung innerhalb der Kühlvorrichtung, erlaubt eine Anordnung für einen Ein- und einen Auslass des Kühlmediums an nur einer der äußeren Flächen des Kühlkörpers.

Dabei kann der Kühlkörper auch derart ausgebildet sein, dass sich ein Ein- und ein Auslass des Kühlmediums statt an der Grundflächenöffnung an der Deckflächenöffnung befindet, der Aufbau der Kühlvorrichtung ist dann seitenverkehrt zu betrachten.

Besonders vorteilhaft ist daher die annähernd parallele Anordnung des ersten gegenüber dem zweiten Kühlkanal, welche im Betrieb der Kühlvorrichtung den Kühlstrom des Kühlmediums bevorzugt in entgegengesetzter Richtung aneinander vorbeiführen können. Die räumliche Trennung der beiden aneinander vorbeiführenden Kühlkanäle verhindert wesentlich eine strömungstechnische Vermischung des von außen aufgenommenen Kühlmediums mit dem nach außen abzugebenden Kühlmedium.

Das im Inneren der Kühlvorrichtung angeordnete Schaufelrad kann neben seiner Funktion als Förderer des Kühlmediums auch eine Verdichtung des Kühlmediums bewirken. Es können dabei je nach Anwendungsart sowohl Radialschaufelräder wie auch Axialschaufelräder vorgesehen sein.

Die Verdichtung des Kühlmediums überwindet in vorteilhafter Weise einen möglichen Druckverlust, welcher sich im Betrieb ggf. bei räumlich größeren Kühlvorrichtungen mit langen Kühlstrecken im Vergleich zu davon abweichenden Kühlsystemen einstellen kann. Der Einsatz des Schaufelrades als im Wesentlichen als Förderer oder als eine Kombination von Förderung und Verdichtung des Kühlmediums ist u.a. durch den geometrischen Aufbau und die Anordnung seiner Schaufeln an seiner Schaufelradwelle bestimmt.

Die für die Erfindung vorgesehenen Kühlrippen schließen dabei eine volle Bandbreite von vergleichbaren, für die Entwärmung eingesetzten Aus- und/oder Einbuchtungen am Kühlkörper ein, welche beispielweise Kühllamellen oder Kühlstifte (auch bekannt als Pin-fin Heatsink) sein können.

Die Art, wie das rohrförmige Kühlelement von den an der Innenfläche des Kühlkörpers angeordneten Kühlrippen aufgenommen ist, ermöglicht eine bevorzugte zentrale Anordnung des rohrförmigen Kühlelements im Kühlkörperinnenraum, angeordnet in Längsrichtung zwischen Grundflächenöffnung und Deckflächenöffnung des Kühlkörpers.

Der zweite Kühlkanal, welcher zwischen der Innenfläche des Kühlkörpers und der Außenseite des rohrförmigen Kühlelements gebildet wird, kann durch die im zweiten Kühlkanal entlang des Kühlstroms und in Längsrichtung zwischen der Grundflächenöffnung und der Deckflächenöffnung angeordneten Kühlrippen aufgeteilt sein. Der zweite Kühlkanal weist dann mehrere Teilkühlkanäle auf, welche gegeneinander derart isoliert sein können, dass im Betrieb der Kühlvorrichtung keine Vermischung des Kühlmediums zwischen den benachbarten und derart isolierten Teilkühlkanälen im zweiten Kühlkanal vorgesehen ist.

Im Betrieb der Kühlvorrichtung wird dann beispielsweise der Kühlstrom an der Grundflächenöffnung aufgenommen, durch den ersten Kühlkanal mit der ersten Kühlstromrichtung geleitet, von dem Umlenkmittel umgelenkt, nach Aufnahme der Verlustwärme von den im zweiten Kühlkanal angeordneten Kühlrippendurch den zweiten Kühlkanal in der zweiten Kühlstromrichtung geleitet und über die Grundflächenöffnung wieder abgegeben.

Eine umgekehrte Führung des Kühlstroms ist jedoch in vorteilhafter Weise ebenso durchführbar. Ein Reversieren der Führung des Kühlstroms kann somit je nach Anwendungsfall im Betrieb der Kühlvorrichtung erfolgen.

Vorteilhafte Ausgestaltungsformen des Energieversorgungssystems sind in den abhängigen Ansprüchen angegeben.

Bei einer ersten vorteilhaften Ausgestaltungsform der erfindungsgemäßen Kühlvorrichtung ist eine dem Kühlkörperinnenraum zugewandte Vertiefung des Kühlkörperdeckels derart ausgebildet, den Mantelumfang des sich im Betrieb der Kühlvorrichtung durch die rotierenden Schaufeln des Schaufelrades bildenden Rotationskörpers teilweise oder vollständig zu umgeben.

Insbesondere durch die vollständige Aufnahme der Schaufeln des Schaufelrades in den Kühlkörperdeckel, wobei im rotierenden Betrieb des Schaufelrades die Größenverhältnisse der Schaufeln durch den Mantelumfang des sich bildenden Rotationskörpers bestimmt sind, kann der Kühlkörperinnenraum des Kühlkörpers mit dem rohrförmigen Kühlelement je nach Anwendungsfall in vorteilhafter Weise verschieden dimensioniert werden, ohne dass eine Anpassung an das Schaufelrad, also im Wesentlichen an die Form und Größe der Schaufeln, erfolgen muss.

Bei einer weiteren vorteilhaften Ausgestaltungsform der erfindungsgemäßen Kühlvorrichtung sind eine Einbuchtung in den Kühlrippen an der Deckflächenöffnung des Kühlkörpers und eine Kühlelementausbuchtung des rohrförmigen Kühlelements derart ausgebildet, den Mantelumfang des sich im Betrieb der Kühlvorrichtung durch die rotierenden Schaufeln des Schaufelrades bildenden Rotationskörpers teilweise oder vollständig zu umgeben.

Insbesondere durch die vollständige Aufnahme der Schaufeln des Schaufelrades in den Kühlkörper kann der Kühlkörperdeckel des Kühlkörpers mit dem rohrförmigen Kühlelement je nach Anwendungsfall in vorteilhafter Weise verschieden dimensioniert werden, ohne dass eine Anpassung an das Schaufelrad, also im Wesentlichen an die Form und Größe der Schaufeln, erfolgen muss.

Bei einer weiteren vorteilhaften Ausgestaltungsform der erfindungsgemäßen Kühlvorrichtung sind eine dem Kühlkörperinnenraum zugewandte Vertiefung des Kühlkörperdeckels in einer Umgebungskombination mit einer Einbuchtung in den Kühlrippen im Kühlkörperinnenraum an der Deckflächenöffnung des Kühlkörpers und einer Kühlelementausbuchtung des rohrförmigen Kühlelements derart ausgebildet, den Mantelumfang des sich im Betrieb der Kühlvorrichtung durch die rotierenden Schaufeln des Schaufelrades bildenden Rotationskörpers teilweise oder vollständig zu umgeben.

Ein Einschluss zumindest des Schaufelrades in das Innere der Kühlvorrichtung bewirkt bei jeder der aufgezeigten Ausgestaltungsformen eine vorteilhafte Reduzierung der Laufgeräusche des Schaufelrades im Betrieb. Auch schützt eine derartige Kapselung des Schaufelrades vor mechanischer Beschädigung und vor übermäßiger Verschmutzung von außerhalb der Kühlvorrichtung.

Bei einer weiteren vorteilhaften Ausgestaltungsform der erfindungsgemäßen Kühlvorrichtung weist das Umlenkmittel eine Abrundung in der dem Kühlkörperinnenraum zugewandten Vertiefung des Kühlkörperdeckels auf und wird mittels der Abrundung der Kühlstrom im Betrieb der Kühlvorrichtung im Wesentlichen umgelenkt.

Diese Ausgestaltungsform erlaubt in vorteilhafter Weise, ausgehend von einer konstruktive Ausprägung der Abrundung im Kühlkörperdeckel, eine einfach zu projektierende und herzustellende Lösung zur Umlenkung des im Betrieb der Kühlvorrichtung erzeugten Kühlstroms vom ersten Kühlkanal zum zweiten Kühlkanal oder umgekehrt. Mittels der Abrundung im Kühlkörperdeckel als Umlenkmittel kann das Schaufelrad beispielsweise vollständig im Kühlkörperinnenraum integriert sein, wobei es dann beispielsweise für die Förderung des Kühlstromes allein ausgelegt werden kann. Eine gleichzeitig auch verdichtende Funktionalität ist möglich.

Bei einer weiteren vorteilhaften Ausgestaltungsform der erfindungsgemäßen Kühlvorrichtung weist das Umlenkmittel das Schaufelrad auf und wird mittels des Schaufelrades der Kühlstrom im Betrieb der Kühlvorrichtung im Wesentlichen umgelenkt.

Das Schaufelrad als Umlenkmittel ist bei diesem Anwendungsfall konstruktiv derart ausgelegt, dass im Allgemeinen sowohl die geometrische Auslegung und Anordnung der Schaufeln des Schaufelrades wie auch die dem Kühlkörperdeckel zugewandten und eine Abschlussplatte des Schaufelrades bildenden, miteinander verbundenen Schaufelkanten die Umlenkung des Kühlstromes im Betrieb der Kühlvorrichtung bewirken.

Bei einer weiteren vorteilhaften Ausgestaltungsform der erfindungsgemäßen Kühlvorrichtung weist das Umlenkmittel eine Umlenkkombination aus einer Abrundung in der dem Kühlkörperinnenraum zugewandten Vertiefung des Kühlkörperdeckels und aus dem Schaufelrad auf und mittels der Umlenkkombination wird der Kühlstrom im Betrieb der Kühlvorrichtung im Wesentlichen umgelenkt.

Die Umlenkkombination erlaubt für die konstruktive Ausgestaltung des Umlenkmittels in vorteilhafter Weise eine Vielzahl von Ausgestaltungsmöglichkeiten für verschiedene Anwendungsfälle (z.B. in Industrie, Energieversorgung und Elektrofahrzeugen) beim Einsatz der Kühlvorrichtung, welche sich nicht nur auf eine Verbesserung des Wirkungsgrades der Kühlvorrichtung beziehen, sondern auch auf eine Verbesserung der räumlichen Anordnung innerhalb der Kühlvorrichtung sowie in Bezug auf eine weitere räumliche Anordnung der Kühlvorrichtung in einer Aufbaustruktur eines elektrischen Gerätes, beispielsweise der eines elektrischen Umrichters, beziehen.

Bei einer weiteren vorteilhaften Ausgestaltungsform der erfindungsgemäßen Kühlvorrichtung ist das Schaufelrad über seine Schaufelradwelle mit einer Antriebseinheit verbunden, ist das Schaufelrad derart ausgebildet, im Betrieb der Kühlvorrichtung mit einer ersten Drehrichtung und mit einer zweiten Drehrichtung zu rotieren, wird der Kühlstrom mittels der ersten Drehrichtung derart erzeugt, dass das Kühlmedium an der Grundflächenöffnung aufgenommen wird, wird das Kühlmedium durch den ersten Kühlkanal geleitet, wird das Kühlmedium mittels des Umlenkmittels umgelenkt, wird das Kühlmedium durch den zweiten Kühlkanal geleitet und wird das Kühlmedium an der Grundflächenöffnung abgegeben oder wird der Kühlstrom mittels der zweiten Drehrichtung derart erzeugt, dass das Kühlmedium an der Grundflächenöffnung aufgenommen wird, wird das Kühlmedium durch den zweiten Kühlkanal geleitet, wird das Kühlmedium mittels des Umlenkmittels umgelenkt, wird das Kühlmedium durch den ersten Kühlkanal geleitet und wird das Kühlmedium an der Grundflächenöffnung abgegeben.

Mit dieser Ausgestaltungsform erhält die Kühlvorrichtung weitere Freiheitsgrade für den Einsatz in elektrischen Geräten, beispielsweise in elektrischen Umrichtern. So ist es möglich, im Betrieb der Kühlvorrichtung, auch bei voller Belastung der Kühlvorrichtung, den Kühlstrom in die Gegenrichtung zu leiten. Beispielsweise würde der erste Kühlkanal, welcher beim Anliegen der ersten Drehrichtung des im Betrieb rotierenden Schaufelrades mittels des Kühlstroms das Kühlmedium an der Grundflächenöffnung aufnehmen und zum Umlenkmittel weiterleiten. Nach Anlegen der zweiten Drehrichtung reversiert sich die Richtung des Kühlstroms mit dem Kühlmedium und gibt das Kühlmedium vom Umlenkmittel kommend über die Grundflächenöffnung nach außerhalb der Kühlvorrichtung ab.

Die Lagerung der Schaufelradwelle des Schaufelrades kann allein über ein erstes Lager, welches in einer ersten Lagerhalterung am Kühlkörperdeckel angeordnet ist, gelagert werden. Als Gegenlager, aber auch als weiteres alleiniges Lager, kann ein zweites Lager, welches in einer zweiten Lagerhalterung am bzw. im rohrförmigen Kühlelement angeordnet ist, für die Lagerung der Schaufelradwelle des Schaufelrades vorgesehen sein.

Das Schaufelrad kann ferner über seine Schaufelradwelle auch derart mit der Antriebseinheit, beispielsweise direkt mit einer Antriebswelle einer elektrischen Maschine, verbunden sein, dass eine Lagerung der Schaufelradwelle des Schaufelrades an der oder in der Kühlvorrichtung entfallen kann.

Derartige Betriebsfälle mit einer Drehrichtungsänderung des Schaufelrades können beispielsweise dann vorliegen, wenn die Kühlvorrichtung neben der kühlenden Funktion zeitweise auch eine heizende Funktion aufweisen soll. Die kann beispielsweise beim Einsatz in kalten Regionen notwendig werden, wo anfangs als eine Art Starthilfe vorgewärmtes Kühlmedium zur Aufwärmung von beispielsweise elektronischen Bauelementen benötigt wird und diese später mittels des Kühlmediums wieder entwärmen werden müssen.

Bei einer weiteren vorteilhaften Ausgestaltungsform der erfindungsgemäßen Kühlvorrichtung ist ein Trichterelement an der Grundflächenöffnung des Kühlkörpers mechanisch mit dem Kühlkörper und dem rohrförmigen Kühlelement verbunden, ist eine erste Trichterelementöffnung des Trichterelements an der Grundflächenöffnung und an dem ersten Kühlkanal derart angeordnet, dass der Kühlstrom des Kühlmediums im Betrieb der Kühlvorrichtung von dem ersten Kühlkanal zur ersten Trichterelementöffnung oder von der ersten Trichterelementöffnung zum ersten Kühlkanal geleitet wird, ist eine zweite Trichterelementöffnung des Trichterelements an der Grundflächenöffnung und an dem zweiten Kühlkanal derart angeordnet, dass der Kühlstrom des Kühlmediums im Betrieb der Kühlvorrichtung von dem zweiten Kühlkanal zur zweiten Trichterelementöffnung oder von der zweiten Trichterelementöffnung zum ersten Kühlkanal geleitet wird und ist eine Trichterelementwand im Inneren des Trichterelements derart ausgebildet, dass im Betrieb der Kühlvorrichtung eine Vermischung des Kühlstroms im Trichterelement, welcher durch die erste Trichterelementöffnung geleitet wird, mit dem Kühlstrom, welcher durch die zweite Trichterelementöffnung geleitet wird, verhindert wird.

Die Ausgestaltungsform mit dem Trichterelement verhindert demnach in vorteilhafter Weise, dass das noch nicht erwärmte Kühlmedium, welches beispielsweise im Betrieb der Kühlvorrichtung durch die erste Trichterelementöffnungen aufgenommen wird, mit dem erwärmten Kühlmedium, welches im Betrieb der Kühlvorrichtung demnach durch die zweite Trichterelementöffnungen abgegeben wird, vermischt wird, also in diesem Fall unerwünscht vorgeheizt wird.

Bei einer weiteren vorteilhaften Ausgestaltungsform der erfindungsgemäßen Kühlvorrichtung ist das rohrförmige Kühlelement aus einem Kunststoff oder einem einen Kunststoff enthaltenden Verbundmaterial gebildet.

Kunststoff lässt sich auch als Verbundmaterial (Aufspritzen von Kunststoff auf andere Materialien) vergleichsweise preiswert und einfach herstellen. Es weist an seinen Verbindungsstellen zu einem weiteren Bauteil eine weit bessere Abdichtungsfunktionalität als beispielsweise Metall allein auf. Darüber hinaus ist der Wärmeleitwert von Kunststoff auch wesentlich kleiner als von Metall, was der meist gewünschten thermisch isolierenden Funktionalität des rohrförmigen Kühlelements gerecht wird.

Bei einer weiteren vorteilhaften Ausgestaltungsform der erfindungsgemäßen Kühlvorrichtung ist das rohrförmige Kühlelement einteilig oder mehrteilig ausgebildet.

Diese Ausgestaltungsform kann, je nach Herstellungstechnologie und Aufbaukonzept, besonders förderlich für den Einsatz der modular aufgebauten Kühlvorrichtung sein. Wird das rohrförmige Kühlelement einteilig ausgebildet, ist eine Herstellung oft aufwändig, der Einbau in die Kühlvorrichtung ist jedoch eher schnell durchgeführt. Umgekehrt ist bei der mehrteiligen Ausbildung des rohrförmigen Kühlelements die Herstellung einzelner Elemente der Kühlvorrichtung im Allgemeinen mit geringem Aufwand durchführbar, der Zusammenbau der einzelnen Elemente gestaltet sich jedoch meist als aufwändig.

Bei einer weiteren vorteilhaften Ausgestaltungsform der erfindungsgemäßen Kühlvorrichtung weist das mehrteilige rohrförmige Kühlelement ein Führungselement, eine Abstandshalterung, ein erstes Kopplungselement, welches der Deckflächenöffnung zugewandt ist, und ein zweites Kopplungselement, welches der Grundflächenöffnung zugewandt ist, auf.

Das Führungselement nimmt bei der mehrteiligen Ausbildung des rohrförmigen Kühlelements eine vorteilhafte integrierende Funktion ein. Die Abstandshalterung definiert dabei eine passgenaue Einbringung des ersten und des zweiten Koppelelements.

Bei einer weiteren vorteilhaften Ausgestaltungsform der erfindungsgemäßen Kühlvorrichtung ist das Kühlmedium gasförmig oder flüssig.

Somit ist die Kühlvorrichtung in vorteilhafter Weise auch für Anwendungen mit Flüssigkeitskühlung einsetzbar.

Bei einer weiteren vorteilhaften Ausgestaltungsform der erfindungsgemäßen Kühlvorrichtung sind die Mantelfläche und/oder eine nach außen gerichtete Deckelfläche des Kühlkörperdeckels zur mechanischen und thermischen Verbindung des Kühlkörpers mit mindestens einem elektronischen Bauelement vorgesehen und wird das mindestens eine elektronische Bauelement über diese Verbindung im Betrieb der Kühlvorrichtung entwärmt.

Insbesondere die Nutzung des Kühlkörperdeckels erhöht in vorteilhafter Weise die für die Entwärmung des mindestens einen elektronischen Bauelements verfügbare Fläche. Das mindestens eine elektronische Bauelement kann dabei auch derart geometrisch komplex an der jeweiligen Außenseite des Kühlkörpers und des Kühlkörperdeckels angeordnet sein, dass im Wesentlichen deren gesamte Fläche für die Entwärmung genutzt wird.

Für die Lösung der Aufgabe ist ebenfalls ein elektrischer Umrichter mit einer erfindungsgemäßen Kühlvorrichtung zur Kühlung von mindestens einem elektronischen Bauelement vorgesehen, wobei der elektrische Umrichter an einem elektrischen Netz betreibbar ist und der elektrische Umrichter im Betrieb eine elektrische Maschine oder ein weiteres elektrisches Netz mit elektrischer Energie versorgt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Querschnittsdarstellung der erfindungsgemäßen Kühlvorrichtung,
- FIG 2: eine Detaildarstellung der schematischen Querschnittsdarstellung der erfindungsgemäßen Kühlvorrichtung nach FIG 1,
- FIG 3: eine weitere schematische Querschnittsdarstellung eines Trichterelements mit einer ersten und einer zweiten Trichterelementöffnung angeordnet am Kühlkörpers der erfindungsgemäßen Kühlvorrichtung nach FIG 1 und
- FIG 4: eine schematische Darstellung eines elektrischen Umrichters am elektrischen Netz mit der erfindungsgemäßen Kühlvorrichtung.

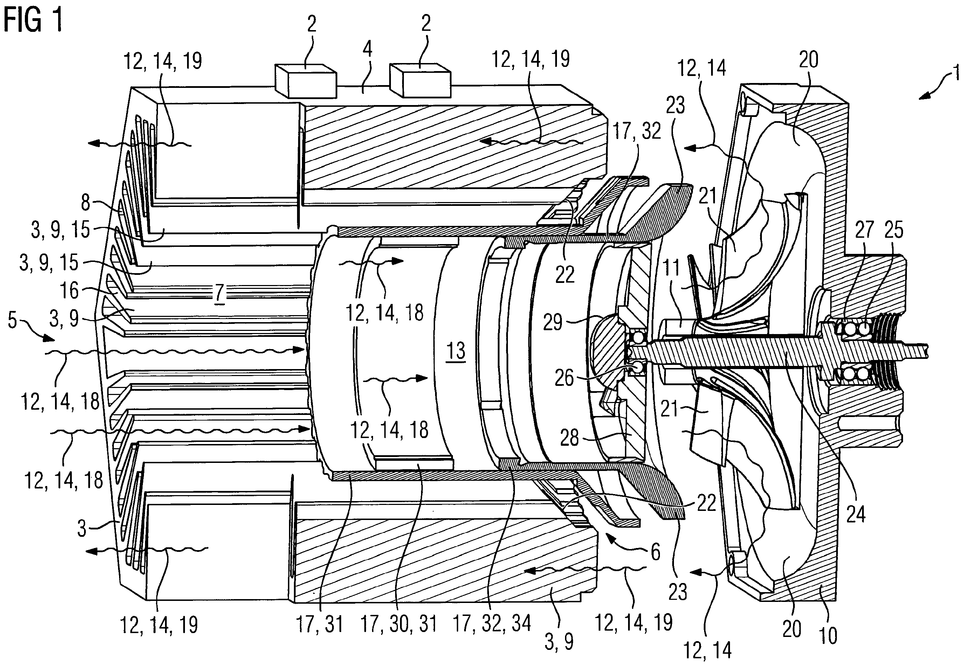

In FIG 1 wird eine schematische Querschnittsdarstellung der erfindungsgemäßen Kühlvorrichtung 1 gezeigt, wobei die Querschnittsdarstellung eine Explosionsdarstellung ist. Der Querschnitt wurde dabei mittig über die gesamte Länge der Kühlvorrichtung 1, angefangen von der Grundflächenöffnung 5 des Kühlkörpers 3, über die Deckflächenöffnung 6 des Kühlkörpers 3 bis zum Kühlkörperdeckel 10 gelegt.

Dargestellt ist ein Aufbaubeispiel einer erfindungsgemäßen Kühlvorrichtung 1 und eines sich beispielhaft beim Betrieb der Kühlvorrichtung 1 einstellenden Kühlstroms 14 eines Kühlmediums 12. Der Kühlstrom 14 des Kühlmediums 12 stellt sich im Ausführungsbeispiel ein, indem das Schaufelrad 11 mit einer ersten Drehrichtung rotiert.

Der Kühlkörper 3 der Kühlvorrichtung 1 weist eine äußere Mantelfläche 4, eine Grundflächenöffnung 5, eine der Grundflächenöffnung 5 gegenüberliegende Deckflächenöffnung 6 und eine Innenfläche 8 mit Kühlrippen 9 auf. Die Kühlrippen 9 umfassen an dem von der Innenfläche 8 des Kühlkörpers 3 abgewandten Ende Kühlrippenspitzen 15.

Ein Kühlkörperdeckel 10 verschließt (Explosionszeichnung der FIG 1 zeigt dies nur indirekt) den Kühlkörper 3 an der Deckflächenöffnung 6 des Kühlkörpers 3. Zur Abdichtung dieses Verschlusses kann eine Dichtung zwischen dem Kühlkörper 3 und dem Kühlkörperdeckel 10 vorgesehen sein (in FIG 1 nicht gezeigt).

Im Inneren der Kühlvorrichtung 1 ist an der Deckflächenöffnung 6 das Schaufelrad 11 mit seinen Schaufeln 21 zum Erzeugen des Kühlstroms 14 des Kühlmediums 12 angeordnet. Eine Umgebungskombination von einer dem Kühlkörperinnenraum 7 zugewandte Vertiefung des Kühlkörperdeckels 10, einer Kühlelementausbuchtung 23 an einem rohrförmigen Kühlelement 17 im Kühlkörperinnenraum 7 und einer Einbuchtung 22 in den Kühlrippen 9 des Kühlkörpers 3 im Kühlkörperinnenraum 7 ist an der Deckflächenöffnung 6 des Kühlkörpers 3 derart ausgebildet, dass das Schaufelrad 11 mit seinen Schaufeln 21 sowie zumindest einen Teil einer Schaufelradwelle 24 des Schaufelrades 11 von der Umgebungskombination umgeben wird.

Das rohrförmige Kühlelement 17 ist derart im Kühlkörperinnenraum 7 des Kühlkörpers 3 angeordnet, dass zumindest einige der Kühlrippen 9, im Detail deren Kühlrippenspitzen 15, mit der Außenseite des rohrförmigen Kühlelements 17 im mechanischen Kontakt stehen. Das rohrförmige Kühlelement 17 bildet in seinem Innenraum einen ersten Kühlkanal 13, durch welchen im Betrieb der Kühlvorrichtung 1, mit der beispielhaften Rotation des Schaufelrades 11 in eine erste Drehrichtung, der Kühlstrom 14 hier in eine erste Kühlstromrichtung 18 geleitet wird.

Ein zweiter Kühlkanal 16 wird zwischen der Innenfläche 8 des Kühlkörpers 3 und der Außenseite des rohrförmigen Kühlelements 17 gebildet, durch welchen im Betrieb der Kühlvorrichtung 1 der Kühlstrom 14 in eine zweite Kühlstromrichtung 19 geleitet wird.

Ein Umlenkmittel lenkt im Betrieb der Kühlvorrichtung 1 den Kühlstrom 14 bei der beispielhaft gewählten ersten Drehrichtung des rotierenden Schaufelrades 11 vom ersten Kühlkanal 13 zum zweiten Kühlkanal 16 um. Dabei ist der erste Kühlkanal 13 gegenüber dem zweiten Kühlkanal 16 derart angeordnet, dass die erste Kühlstromrichtung 18 im Wesentlichen entgegengesetzt zur zweiten Kühlstromrichtung 19 ist.

Das Umlenkmittel in FIG 1 ist eine Umlenkkombination, welche aus einer Abrundung 20 in der dem Kühlkörperinnenraum 7 zugewandten Vertiefung des Kühlkörperdeckels 10 und aus dem Schaufelrad 11 gebildet wird. Mittels der Umlenkkombination wird der Kühlstrom 14 im Betrieb der Kühlvorrichtung 1 wie beschrieben im Wesentlichen umgelenkt.

Ebenfalls in FIG 1 dargestellt ist eine mehrteilige Ausbildung des rohrförmigen Kühlelements 17, welches ein Führungselement 31, eine Abstandshalterung 30, ein erstes Kopplungselement 32, welches der Deckflächenöffnung 6 zugewandt ist, und ein zweites Kopplungselement (in FIG 1 nicht gezeigt), welches der Grundflächenöffnung 5 zugewandt ist, aufweist.

Am von der Kühlelementausbuchtung 23 abgewandten Ende, im Inneren des ersten Kopplungselements 32 des rohrförmigen Kühlelements 17, ist eine Begrenzungsnut 34 angeordnet. Diese Begrenzungsnut 34 sichert und verbindet eine zweite Lagerhalterung 28 mechanisch mit dem ersten Kopplungselement 32. Die zweite Lagerhalterung 28 hält das zweite Lager 26 beispielsweis als Gegenlager der Schaufelradwelle 24 des Schaufelrades 11. Zum Schutz des zweiten Lagers 26 vor Verschmutzung und Beschädigung von außerhalb der Kühlvorrichtung 1 ist eine zur Grundflächenöffnung 5 weisende Lagerabdeckung 29 angeordnet.

Die Schaufelradwelle 24 des Schaufelrades 11 wird ferner mittels eines ersten Lagers 25, welches durch eine erste am Kühlkörperdeckel 10 angeordnete Lagerhalterung 27 gehalten wird, gelagert.

An der Mantelfläche 4 sind in FIG 1 beispielhaft zwei elektronische Bauelemente 2 mit dem Kühlkörper 3 mechanisch verbunden, wobei die elektronischen Bauelemente 2 im Betrieb der Kühlvorrichtung 1 mittels dieser mechanischen Verbindung entwärmt werden können. Auch die Außenfläche des Kühlkörperdeckels 10 kann für die Entwärmung weiterer elektronischer Bauelemente genutzt werden (in FIG 1 nicht gezeigt).

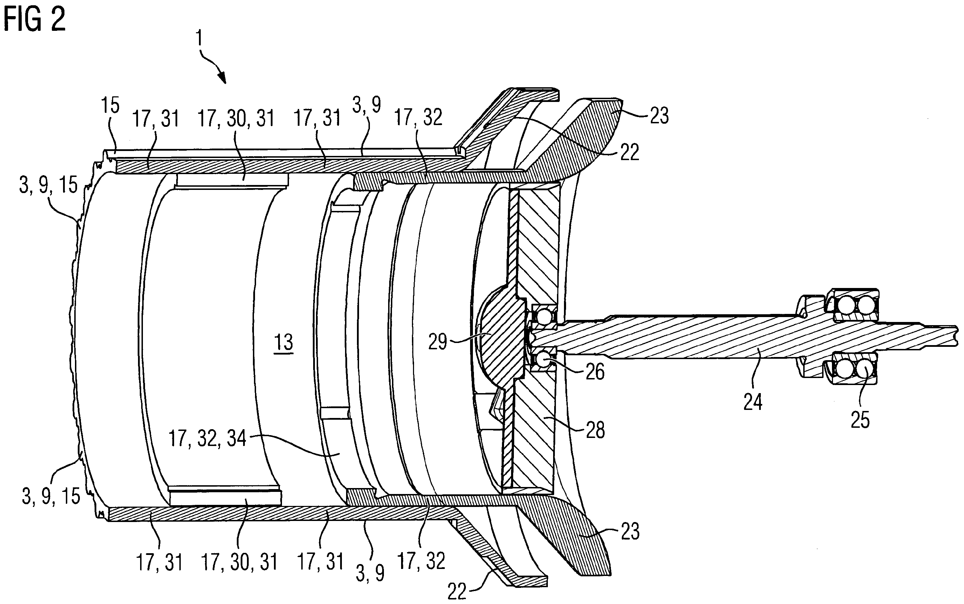

FIG 2 zeigt eine Detaildarstellung der schematischen Querschnittsdarstellung der erfindungsgemäßen Kühlvorrichtung nach FIG 1. Hier wird insbesondere das rohrförmige Kühlelement 17 dargestellt, welches den ersten Kühlkanal 13 bildet und, wie schon beschrieben, beispielhaft mehrteilig ausgeführt ist (das zweite Kopplungselement wird in FIG 2 nicht gezeigt). Ferner wird vergleichbar zu FIG 1 und deren Beschreibung ebenfalls die Lagerung der Schaufelradwelle 24 des Schaufelrades 11 aufgezeigt.

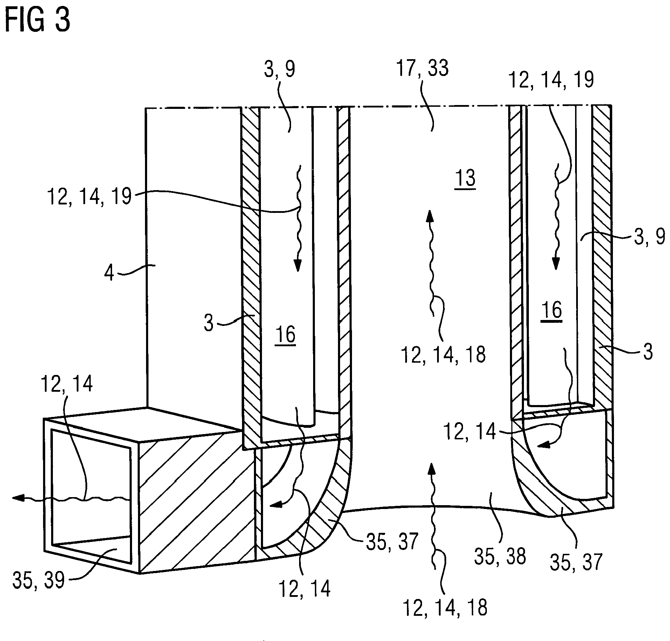

Mit FIG 3 wird eine weitere schematische Querschnittsdarstellung eines Trichterelements 35 mit einer ersten und einer zweiten Trichterelementöffnung 38,39 dargestellt, welche am Kühlkörper 3 der erfindungsgemäßen Kühlvorrichtung 1 nach FIG 1 angeordnet sind.

Das Trichterelement 35 ist an der Grundflächenöffnung (in FIG 3 nicht gezeigt, aber vergleichbar mit der Grundflächenöffnung 5 in FIG 1) des Kühlkörpers 3 mechanisch mit dem Kühlkörper 3 und dem rohrförmigen Kühlelement 17 verbunden. Das hier gezeigte rohrförmige Kühlelement 17 ist mehrteilig ausgebildet. Zu sehen ist in FIG 3 daher ein zweites Kopplungselement 33 des rohrförmigen Kühlelements 17.

Eine erste Trichterelementöffnung 38 des Trichterelements 35 ist an der Grundflächenöffnung des Kühlkörpers 3 und an dem ersten Kühlkanal 13 angeordnet. Beispielhaft wird der Kühlstrom 14 des Kühlmediums 12 im Betrieb der Kühlvorrichtung 1 von der ersten Trichterelementöffnung 38 zu dem ersten Kühlkanal 13 geleitet. Eine zweite Trichterelementöffnung 39 des Trichterelements 35 ist an der Grundflächenöffnung des Kühlkörpers 3 und an dem zweiten Kühlkanal 16 angeordnet. Dem eben erwähnten Beispiel folgend, wird der Kühlstrom 14 des Kühlmediums 12 im Betrieb der Kühlvorrichtung 1 von dem zweiten Kühlkanal 16 zur zweiten Trichterelementöffnung 39 geleitet.

Eine Trichterelementwand 37 im Inneren des Trichterelements 35 ist derart ausgebildet, dass im Betrieb der Kühlvorrichtung 1 eine Vermischung des Kühlstroms 14 im Trichterelement 35, welcher durch die erste Trichterelementöffnung 38 geleitet wird, mit dem Kühlstrom 14, welcher durch die zweite Trichterelementöffnung 39 geleitet wird, verhindert wird.

Ausgehend von der hier in FIG 3 beispielhaften gewählten Richtung des Kühlstroms 14 ist es vorteilhaft, insbesondere für die Aufnahme des Kühlmediums 12 durch den Kühlstrom 14 an der hier gezeigten ersten Trichterelementöffnung 38 eine nach außen gewölbte geometrische Form eines Trompetenkopfes für das Trichterelement 35 zu wählen. Durch diese geometrische Form des Trompetenkopfes werden an dieser Stelle günstige Strömungsverhältnisse gebildet, wenn im Betrieb der Kühlvorrichtung 1 das Kühlmedium 12 mittels des Kühlstromes 14 an der ersten Trichterelementöffnung 38 aufgenommen wird.

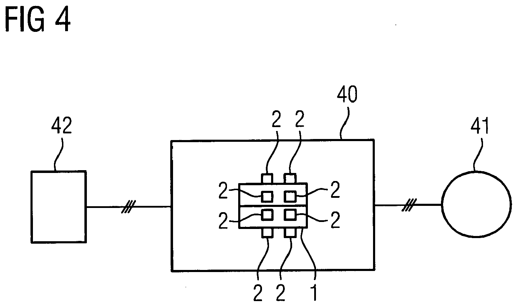

Eine schematische Darstellung eines elektrischen Umrichters 40 am elektrischen Netz 42 mit der erfindungsgemäßen Kühlvorrichtung 1 wird mit FIG 4 gezeigt.

Der elektrische Umrichter 40 weist die Kühlvorrichtung 1 zusammen mit beispielhaft sechs zu entwärmenden elektronischen Bauelementen 2 auf und ist mittels einer dreiphasigen elektrischen Leitung aus dem elektrischen Netz 42 mit elektrischer Energie betreibbar. Eine elektrische Maschine 41 ist durch den elektrischen Umrichter 40 mittels eines dreiphasiger elektrische Leitungen betreibbar. Nicht in FIG 4 dargestellt ist die Möglichkeit, ein weiteres elektrisches Netz mittels des elektrischen Umrichters 40 mit elektrischer Energie zu versorgen.

## Patentansprüche

1. Kühlvorrichtung (1) zur Kühlung mindestens eines elektronischen Bauelements (2), umfassend
- einen Kühlkörper (3), welcher eine äußere Mantelfläche (4), eine Grundflächenöffnung (5), eine der Grundflächenöffnung (5) gegenüberliegende Deckflächenöffnung (6) und eine Innenfläche (8) mit Kühlrippen (9) aufweist,
- einen Kühlkörperdeckel (10),
- ein rohrförmiges Kühlelement (17) und
- ein Schaufelrad (11) mit Schaufeln (21) zum Erzeugen eines Kühlstroms (14) eines Kühlmediums (12),
wobei
- die Deckflächenöffnung (6) durch den Kühlkörperdeckel (10) verschlossen ist,
- das rohrförmige Kühlelement (17) derart im Kühlkörperinnenraum (7) des Kühlkörper(3) angeordnet ist, dass zumindest einige der Kühlrippen (9) mit der Außenseite des rohrförmigen Kühlelements (17) in einem mechanischen Kontakt stehen,
- das rohrförmige Kühlelement (17) in seinem Innenraum einen ersten Kühlkanal (13) bildet, durch welchen im Betrieb der Kühlvorrichtung (1) der Kühlstrom (14) in eine erste Kühlstromrichtung (18) geleitet wird,
- ein zweiter Kühlkanal (16) zwischen der Innenfläche (8) des Kühlkörpers (3) und der Außenseite des rohrförmigen Kühlelements (17) gebildet wird, durch'welchen im Betrieb der Kühlvorrichtung (1) der Kühlstrom (14) in eine zweite Kühlstromrichtung (19) geleitet wird,
- ein Umlenkmittel im Betrieb der Kühlvorrichtung (1) den Kühlstrom (14) vom ersten Kühlkanal (13) zum zweiten Kühlkanal (16) oder vom zweiten Kühlkanal (16) zum ersten Kühlkanal (13) umlenkt und
- der erste Kühlkanal (13) gegenüber dem zweiten Kühlkanal (16) derart angeordnet ist, dass die erste Kühlstromrichtung (18) im Wesentlichen entgegengesetzt zur zweiten Kühlstromrichtung (19) ist.

2. Kühlvorrichtung (1) nach Anspruch 1, wobei eine dem Kühlkörperinnenraum (7) zugewandte Vertiefung des Kühlkörperdeckels (10) derart ausgebildet ist, den Mantelumfang des sich im Betrieb der Kühlvorrichtung (1) durch die rotierenden Schaufeln (21) des Schaufelrades (11) bildenden Rotationskörpers teilweise oder vollständig zu umgeben.

3. Kühlvorrichtung (1) nach Anspruch 1, wobei eine Einbuchtung (22) in den Kühlrippen (9) an der Deckflächenöffnung (6) des Kühlkörpers (3) und eine Kühlelementausbuchtung (23) des rohrförmigen Kühlelements (17) derart ausgebildet sind, den Mantelumfang des sich im Betrieb der Kühlvorrichtung (1) durch die rotierenden Schaufeln (21) des Schaufelrades (11) bildenden Rotationskörpers teilweise oder vollständig zu umgeben.

4. Kühlvorrichtung (1) nach Anspruch 1, wobei eine dem Kühlkörperinnenraum (7) zugewandte Vertiefung des Kühlkörperdeckels (10) in einer Umgebungskombination mit einer Einbuchtung (22) in den Kühlrippen (9) im Kühlkörperinnenraum (7) an der Deckflächenöffnung (6) des Kühlkörpers (3) und einer Kühlelementausbuchtung (23) des rohrförmigen Kühlelements (17) derart ausgebildet sind, den Mantelumfang des sich im Betrieb der Kühlvorrichtung (1) durch die rotierenden Schaufeln (21) des Schaufelrades (11) bildenden Rotationskörpers teilweise oder vollständig zu umgeben.

5. Kühlvorrichtung (1) nach einem der vorhergehenden Ansprüche, wobei das Umlenkmittel eine Abrundung (20) in der dem Kühlkörperinnenraum (7) zugewandten Vertiefung des Kühlkörperdeckels (10) aufweist und mittels der Abrundung (20) der Kühlstrom (14) im Betrieb der Kühlvorrichtung (1) im Wesentlichen umgelenkt wird.

6. Kühlvorrichtung (1) nach einem der Ansprüche 1 bis 4, wobei das Umlenkmittel das Schaufelrad (11) aufweist und mittels des Schaufelrades (11) der Kühlstrom (14) im Betrieb der Kühlvorrichtung (1) im Wesentlichen umgelenkt wird.

7. Kühlvorrichtung (1) nach einem der Ansprüche 1 bis 4, wobei das Umlenkmittel eine Umlenkkombination aus einer Abrundung (20) in der dem Kühlkörperinnenraum (7) zugewandten Vertiefung des Kühlkörperdeckels (10) und aus dem Schaufelrad (11) aufweist und mittels der Umlenkkombination der Kühlstrom (14) im Betrieb der Kühlvorrichtung (1) im Wesentlichen umgelenkt wird.

8. Kühlvorrichtung (1) nach einem der vorhergehenden Ansprüche, wobei
- das Schaufelrad (11) über seine Schaufelradwelle (24) mit einer Antriebseinheit verbunden ist,
- das Schaufelrad (11) derart ausgebildet ist, im Betrieb der Kühlvorrichtung (1) mit einer ersten Drehrichtung und mit einer zweiten Drehrichtung zu rotieren,
- der Kühlstrom (14) mittels der ersten Drehrichtung derart erzeugt wird, dass das Kühlmedium (12) an der Grundflächenöffnung (5) aufgenommen wird, das Kühlmedium (12) durch den ersten Kühlkanal (13) geleitet wird, das Kühlmedium (12) mittels des Umlenkmittels umgelenkt wird, das Kühlmedium (12) durch den zweiten Kühlkanal (16) geleitet wird und das Kühlmedium (12) an der Grundflächenöffnung (5) abgegeben wird oder
- der Kühlstrom (14) mittels der zweiten Drehrichtung derart erzeugt wird, dass das Kühlmedium (12) an der Grundflächenöffnung (5) aufgenommen wird, das Kühlmedium (12) durch den zweiten Kühlkanal (16) geleitet wird, das Kühlmedium (12) mittels des Umlenkmittels umgelenkt wird, das Kühlmedium (12) durch den ersten Kühlkanal (13) geleitet wird und das Kühlmedium (12) an der Grundflächenöffnung (5) abgegeben wird.

9. Kühlvorrichtung (1) nach einem der vorhergehenden Ansprüche, wobei
- ein Trichterelement (35) an der Grundflächenöffnung (5) des Kühlkörpers (3) mechanisch mit dem Kühlkörper (3) und dem rohrförmigen Kühlelement (17) verbunden ist,
- eine erste Trichterelementöffnung (38) des Trichterelements (35) an der Grundflächenöffnung (5) und an dem ersten Kühlkanal (13) derart angeordnet ist, dass der Kühlstrom (14) des Kühlmediums (12) im Betrieb der Kühlvorrichtung (1) von dem ersten Kühlkanal (13) zur ersten Trichterelementöffnung (38) oder von der ersten Trichterelementöffnung (38) zum ersten Kühlkanal (13) geleitet wird,
- eine zweite Trichterelementöffnung (39) des Trichterelements (35) an der Grundflächenöffnung (5) und an dem zweiten Kühlkanal (16) derart angeordnet ist, dass der Kühlstrom (14) des Kühlmediums (12) im Betrieb der Kühlvorrichtung (1) von dem zweiten Kühlkanal (16) zur zweiten Trichterelementöffnung (39) oder von der zweiten Trichterelementöffnung (39) zum ersten Kühlkanal (16) geleitet wird und
- eine Trichterelementwand (37) im Inneren des Trichterelements (35) derart ausgebildet ist, dass im Betrieb der Kühlvorrichtung (1) eine Vermischung des Kühlstroms (14) im Trichterelement (35), welcher durch die erste Trichterelementöffnung (38) geleitet wird, mit dem Kühlstrom (14), welcher durch die zweite Trichterelementöffnung (39) geleitet wird, verhindert wird.

10. Kühlvorrichtung (1) nach einem der vorhergehenden Ansprüche, wobei das rohrförmige Kühlelement (17) aus einem Kunststoff oder einem einen Kunststoff enthaltenden Verbundmaterial gebildet ist.

11. Kühlvorrichtung (1) nach einem der vorhergehenden Ansprüche, wobei das rohrförmige Kühlelement (17) einteilig oder mehrteilig ausgebildet ist.

12. Kühlvorrichtung (1) nach Anspruch 11, wobei das mehrteilige rohrförmige Kühlelement (17) ein Führungselement (31), eine Abstandshalterung (30), ein erstes Kopplungselement (32), welches der Deckflächenöffnung (6) zugewandt ist, und ein zweites Kopplungselement (33), welches der Grundflächenöffnung (5) zugewandt ist, aufweist.

13. Kühlvorrichtung (1) nach einem der vorhergehenden Ansprüche, wobei das Kühlmedium (12) gasförmig oder flüssig ist.

14. Kühlvorrichtung (1) nach einem der vorhergehenden Ansprüche, wobei die Mantelfläche (4) und/oder eine nach außen gerichtete Deckelfläche des Kühlkörperdeckels (10) zur mechanischen und thermischen Verbindung des Kühlkörpers (3) mit mindestens einem elektronischen Bauelement (2) vorgesehen sind und das mindestens eine elektronische Bauelement (2) über diese Verbindung im Betrieb der Kühlvorrichtung (1) entwärmt wird.

15. Elektrischer Umrichter (40) mit einer Kühlvorrichtung (1) zur Kühlung von mindestens einem elektronischen Bauelement (2) nach einem der Ansprüche 1 bis 14, wobei der elektrische Umrichter (40) an einem elektrischen Netz (42) betreibbar ist und der elektrische Umrichter (40) im Betrieb eine elektrische Maschine (41) oder ein weiteres elektrisches Netz mit elektrischer Energie versorgt.
